# EUROPEAN PATENT APPLICATION

(11) **EP 4 773 652 A1**
(43) Date of publication of application: **08.07.2026**
(21) Application number: 23950172.9
(22) Date of filing: 31.08.2023
(51) Int. Cl.: H04W 24/02

(54) **METHOD FOR WIRELESS COMMUNICATION, AND COMMUNICATION DEVICE**

(71) Applicant: GUANGDONG OPPO MOBILE TELECOMMUNICATIONS CORP., LTD., Dongguan, Guangdong 523860 (CN)
(72) Inventor: TIAN, Wenqiang, Dongguan, Guangdong 523860 (CN); ZHENG, Xufei, Dongguan, Guangdong 523860 (CN)
(74) Representative: Mewburn Ellis LLP
(86) International application number: PCT/CN2023/116059
(87) International publication number: WO 2025/043585

(57) **Abstract**

A method for wireless communication and a communication device are provided. The method includes the following. A first device determines a first processing scheme. The first processing scheme is used for performing one or more of the following operations under a first condition: matching an operating characteristic of a power amplifier (PA) of the first device; adjusting a transmission waveform of the first device; and processing a first problem. The first problem is associated with the transmission waveform and/or the operating characteristic of the PA.

## Description

### TECHNICAL FIELD

This disclosure relates to the field of communication technology, and more specifically to a method for wireless communication and a communication device.

### BACKGROUND

There is a problem of non-linear distortion in a power amplifier (PA). For this problem, a digital pre-distortion (DPD) scheme is used for compensating for the non-linear distortion of the PA in the related art.

### SUMMARY

A method for wireless communication and a communication device are provided in embodiments of the disclosure. Various aspects involved in embodiments of the disclosure will be introduced in detail below.

In a first aspect, a method for wireless communication is provided. The method includes the following. A first device determines a first processing scheme. The first processing scheme is used for performing one or more of the following operations under a first condition: matching an operating characteristic of a power amplifier (PA) of the first device; adjusting a transmission waveform of the first device; and processing a first problem. The first problem is associated with the transmission waveform and/or the operating characteristic of the PA.

In a second aspect, a method for wireless communication is provided. The method includes the following. A second device sends target information to a first device, where the target information is used for determining a first processing scheme. The first processing scheme is used for performing one or more of the following operations under a first condition: matching an operating characteristic of a PA of the first device; adjusting a transmission waveform of the first device; and processing a first problem. The first problem is associated with the transmission waveform and/or the operating characteristic of the PA.

In a third aspect, a communication device is provided. The communication device is a first device, and the first device includes a determining module. The determining module is configured to determine a first processing scheme. The first processing scheme is used for performing one or more of the following operations under a first condition: matching an operating characteristic of a PA of the first device; adjusting a transmission waveform of the first device; and processing a first problem. The first problem is associated with the transmission waveform and/or the operating characteristic of the PA.

In a fourth aspect, a communication device is provided. The communication device is a second device, and the second device includes a communication module. The communication module is configured to send target information to a first device, where the target information is used for determining a first processing scheme. The first processing scheme is used for performing one or more of the following operations under a first condition: matching an operating characteristic of a PA of the first device; adjusting a transmission waveform of the first device; and processing a first problem. The first problem is associated with the transmission waveform and/or the operating characteristic of the PA.

In a fifth aspect, a communication device is provided. The communication device includes a transceiver, a memory, and a processor. The memory is configured to store a program, and the processor is configured to invoke the program stored in the memory and control the transceiver to receive or send a signal, to cause the communication device to perform the method described in any one of the first aspect and the second aspect.

In a sixth aspect, an apparatus is provided. The apparatus includes a processor. The processor is configured to invoke a program stored in a memory, to cause the apparatus to perform the method described in any one of the first aspect and the second aspect.

In a seventh aspect, a chip is provided. The chip includes a processor. The processor is configured to invoke a program stored in a memory, to cause a device equipped with the chip to perform the method described in any one of the first aspect and the second aspect.

In an eighth aspect, a computer-readable storage medium is provided. The computer-readable storage medium is configured to store a program which causes a computer to perform the method described in any one of the first aspect and the second aspect.

In a ninth aspect, a computer program product is provided. The computer program product includes a program which causes a computer to perform the method described in any one of the first aspect and the second aspect.

In a tenth aspect, a computer program is provided. The computer program causes a computer to perform the method described in any one of the first aspect and the second aspect.

By using a first processing scheme (for example, a processing scheme for a problem of non-linear distortion of a PA or another problem related to the problem of the non-linear distortion) associated with a specific condition, the processing effect on a corresponding problem can be improved.

### BRIEF DESCRIPTION OF THE DRAWINGS

FIG. 1 is a diagram of an example system architecture of a wireless communication system to which embodiments of the disclosure are applicable.
FIG. 2 is a schematic diagram illustrating an operating principle of a digital pre-distortion scheme.
FIG. 3 is a diagram of an example structure of a neural network.
FIG. 4 is a schematic flowchart of a method for wireless communication provided in an embodiment of the disclosure.
FIG. 5 is a schematic flowchart of a method for wireless communication provided in another embodiment of the disclosure.
FIG. 6 is a schematic flowchart of a method for wireless communication provided in another embodiment of the disclosure.
FIG. 7 is a schematic flowchart of a method for wireless communication provided in another embodiment of the disclosure.
FIG. 8 is a schematic flowchart of a method for wireless communication provided in another embodiment of the disclosure.
FIG. 9 is a schematic flowchart of a method for wireless communication provided in another embodiment of the disclosure.
FIG. 10 is a schematic flowchart of a method for wireless communication provided in another embodiment of the disclosure.
FIG. 11 is a schematic structural diagram of a communication device provided in an embodiment of the disclosure.
FIG. 12 is a schematic structural diagram of a communication device provided in another embodiment of the disclosure.
FIG. 13 is a schematic structural diagram of an apparatus to which embodiments of the disclosure are applicable.

### DETAILED DESCRIPTION

The following will describe technical solutions in the disclosure with reference to the accompanying drawings.

### Communication system architecture

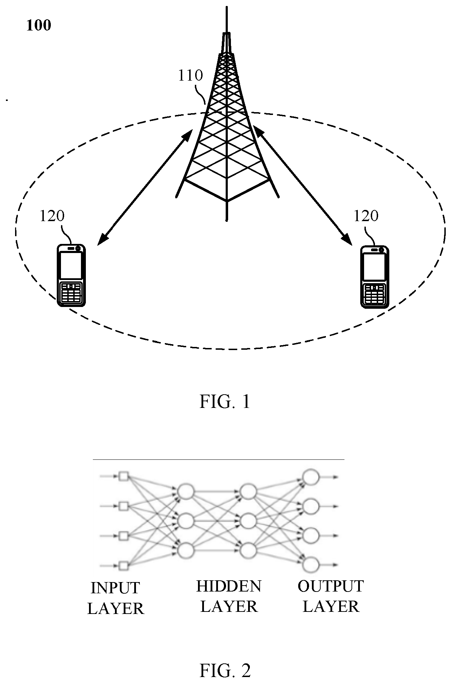

FIG. 1 is a diagram of an example system architecture of a wireless communication system 100 to which embodiments of the disclosure are applicable. The wireless communication system 100 may include a network device 110 and a terminal device 120. The network device 110 may be a device that communicates with the terminal device 120. The network device 110 may provide communication coverage for a specific geographic area and may communicate with the terminal device 120 located within that coverage area.

FIG. 1 exemplarily illustrates one network device and one terminal device. Optionally, the wireless communication system 100 may include one or more network devices 110 and/or one or more terminal devices 120. For one network device 110, the one or more terminal devices 120 may all be located in the network coverage area of the network device 110, all be located out of the network coverage area of the network device 110, or some may be in the coverage area of the network device 110 while others are out of the coverage area of the network device 110. Embodiments of the disclosure are not limited in this regard.

Optionally, the wireless communication system 100 may further include other network entities such as a network controller, a mobility management entity, etc. Embodiments of the disclosure are not limited in this regard.

It may be understood that, the technical solutions of embodiments of the disclosure can be applied to various communication systems, for example: the fifth generation (5G) system or new radio (NR), long term evolution (LTE) system, LTE frequency division duplex (FDD) system, LTE time division duplex (TDD), etc. The technical solutions provided in this disclosure can also be applied to future communication systems, such as the sixth-generation mobile communication system, satellite communication systems, and so on.

The terminal device in embodiments of the disclosure may also be referred to as a user equipment (UE), an access terminal, a subscriber unit, a subscriber station, a mobile station (MS), a mobile terminal (MT), a remote station, a remote terminal, a mobile device, a user terminal, a terminal, a wireless communication device, a user agent, or a user device. The terminal device in embodiments of the disclosure may be a device that provides voice and/or data connectivity to users and can be used to connect people, objects, and machines, such as handheld devices with wireless connectivity, in-vehicle devices, etc. The terminal devices in embodiments of the disclosure may be mobile phones, tablets (Pad), laptop computers, handheld computers, mobile internet devices (MID), wearable devices, virtual reality (VR) devices, augmented reality (AR) devices, wireless terminals in industrial control, wireless terminals in self-driving, wireless terminals in remote medical surgery, wireless terminals in smart grids, wireless terminals in transportation safety, wireless terminals in smart cities, wireless terminals in smart homes, and so on. Optionally, the UE may act as a base station. For example, the UE may act as a scheduling entity that provides sidelink signals between UEs in vehicle-to-everything (V2X) or device-to-device (D2D) communications. For example, cellular phones and automobiles may communicate with each other using sidelink signals. Cellular phones and smart home devices may communicate directly without relaying communication signals through a base station.

The network device in embodiments of the disclosure may be a device for communicating with the terminal device and may also be referred to as an access network device or a radio access network (RAN) device, such as a base station. The network device in embodiments of the disclosure may be an RAN node (or device) that connects the terminal device to the wireless network. The base station may broadly cover various names or be interchangeable with the following names: NodeB, evolved NodeB (eNB), next-generation NodeB (gNB), relay station, access point, transmitting and receiving point (TRP), transmitting point (TP), master station (MeNB), secondary station (SeNB), multi-standard radio (MSR) node, home base station, network controller, access node, wireless node, access point (AP), transmission node, transceiver node, base band unit (BBU), remote radio unit (RRU), active antenna unit (AAU), remote radio head (RRH), central unit (CU), distributed unit (DU), positioning node, etc. The base station may be a macro base station, micro base station, relay node, donor node, or similar, or a combination thereof. The base station may also refer to a communication module, modem, or chip installed within the aforementioned devices or apparatuses. The base station may also be a mobile switching center, a device that performs base station functions in D2D, V2X, machine-to-machine (M2M) communications, a network-side device in a 6G network, a device that performs base station functions in future communication systems, etc. The base station may support networks using the same or different access technologies. There is no limitation on the specific technology and specific device form used by the network device in embodiments of the disclosure.

The base station may be fixed or mobile. For example, a helicopter or drone may be configured to act as a mobile base station, with one or more cells moving according to the position of the mobile base station. In other examples, a helicopter or drone may be configured to act as a device that communicates with another base station.

In some deployments, the network device in embodiments of the disclosure may refer to a CU or DU, or the network device may include a CU and a DU. The gNB may also include an AAU.

The network device and the terminal device may be deployed on land, including indoors or outdoors, handheld or vehicle-mounted; on water; or on aircraft, balloons, and satellites in the air. In embodiments of the disclosure, there is no limitation on the scenario in which the network device and the terminal device are located.

It may be understood that, all or some of functions of the communication device in the disclosure may also be implemented by a software function run on hardware, or may be implemented by a virtualization function instantiated on a platform (for example, a cloud platform).

### Artificial intelligence (AI)

In recent years, researches on AI represented by neural networks have achieved great results in many fields. AI will also play an important role in people's production and life for a long time in the future.

As illustrated in FIG. 2, a basic structure of a neural network may include an input layer, a hidden layer, and an output layer. The input layer may be responsible for receiving data, the hidden layer may be responsible for processing data, and a final result is generated at the output layer. In the neural network, each node represents a processing unit, or each node may be considered as simulating a neuron. Multiple neurons may form a layer of a neural network, and a whole neural network is constructed by multiple layers of information transmission and processing.

With the continuous development of neural network research, a neural network-based deep learning architecture has also been proposed in recent years. In the deep learning architecture, more hidden layers are introduced, and feature learning is performed layer by layer based on a neural network with multiple hidden layers, thereby greatly improving the learning and processing capability of the neural network. Therefore, a deep learning-based neural network is widely used in aspects such as pattern recognition, signal processing, optimization and combination, and abnormality detection.

### Digital pre-distortion (DPD)

A power amplifier (PA) is an important device widely used in a wireless communication system. The PA has a linear region and a non-linear region. Generally, in terms of using the PA, the PA is expected to operate in the linear region. That is to say, it is expected in the wireless communication system that a power range of a signal input to the PA falls in the linear region of the PA, so that the output performance of the PA can be ensured. If the PA operates in the non-linear region, the power amplification of the PA may be influenced, so that the actual output of the PA does not meet the expectation of the wireless communication system, thereby resulting in power loss.

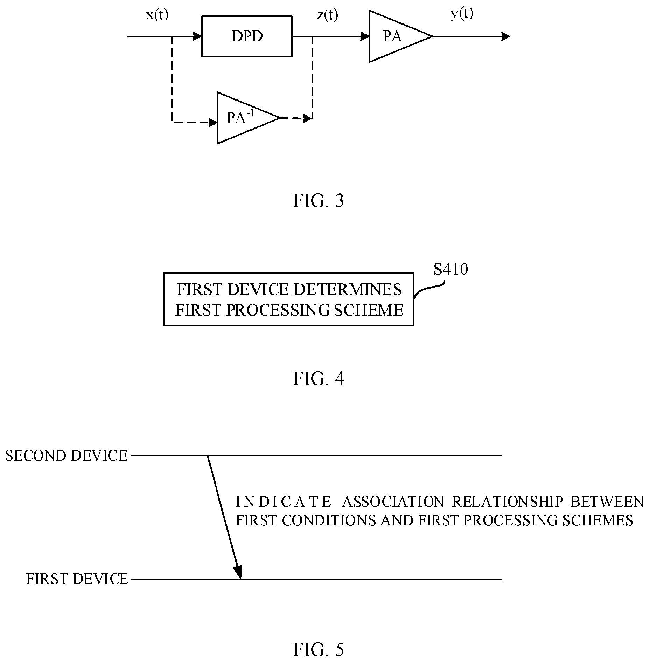

In the DPD technology, a DPD module is usually used to cooperate with the PA. For example, the DPD module may be built in the process of baseband signal processing, so that the DPD module can compensate for power loss caused by non-linear distortion of the PA. As illustrated in FIG. 3, a DPD module may be deployed before a PA. The DPD module may be regarded as an inverse function (as indicated by a dashed line in FIG. 3) of non-linear power amplification of the PA, so as to compensate for power deviation and loss caused by the non-linear power amplification of the PA.

In practice, an operating characteristic (for example, a non-linear characteristic) of the PA is usually not fixed. By analyzing different devices, different chips, different use environments, and different use configurations, it is found that the PA usually exhibits different operating characteristics. Considering the above feature of the PA, an appropriate non-linear processing scheme for the PA is required to match an operating characteristic of the PA under a different condition.

In this case, how to determine the above non-linear processing scheme for the PA under the different condition and how to configure, update, and apply a specific target non-linear processing scheme for the PA are problems that need to be considered and solved in practical engineering applications. For example, PAs used by different devices may have different operating characteristics. For another example, when the same device operates in different frequency bands, a PA may exhibit different operating characteristics. For another example, the same PA may also exhibit different operating characteristics at different operating bandwidths, operating voltages, or operating temperatures. For the above case, a different non-linear processing scheme for a PA need to be used under a different condition, so as to effectively process a non-linear problem of the PA. Further, in terms of introducing multiple processing schemes under different conditions, one or more of the following problems may also need to be considered: the configuration, update, management, capability alignment, use priority, and other problems regarding processing schemes for the non-linear problem of the PA. In addition, it is considered that in terms of introducing a non-linear processing scheme for the PA as part of standardization in the communication system, a provider and a user of the non-linear processing scheme for the PA need to have a consistent understanding on a non-linear processing scheme for the PA that can be used under a different condition.

For at least one of the above problems, the following will provide detailed illustrative examples of embodiments of the disclosure with reference to FIG. 4.

FIG. 4 is a schematic flowchart of a method for wireless communication provided in an embodiment of the disclosure. The method in FIG. 4 may be performed by a first device. The first device may be a terminal device or a network device.

As illustrated in FIG. 4, at S410, a first device determines a first processing scheme.

The first processing scheme can be used for processing a first problem. The first problem may be associated with an operating characteristic of a PA of the first device.

In some embodiments, the operating characteristic of the PA of the first device may refer to a non-linear characteristic of the PA of the first device.

In some embodiments, the first problem may refer to a non-linear problem (or a problem of non-linear distortion) of the PA of the first device.

In some embodiments, the first problem may be a problem that may cause the non-linear distortion of the PA. That is, due to the existence of the first problem, when transmission data of the first device enters the PA for power amplification, the PA may operate in a non-linear region. The first problem is not necessarily the problem of the non-linear distortion of the PA, and may also be another problem that may cause the problem of the non-linear distortion, or may be another problem derived from the problem of the non-linear distortion.

In some embodiments, a cause for the PA to operate in the non-linear region may be an excessively high peak to average power ratio (PAPR) of a transmission. Therefore, in some embodiments, the first problem may be associated with a PAPR of a transmission by the first device. For example, the first problem may be a problem of a poor PAPR of the transmission, or may be another influence brought about by the poor PAPR of the transmission (i.e., a derivative problem of the poor PAPR).

A cause for the PA to operate in the non-linear region may also be a poor adjacent channel leakage ratio (ACLR) of a transmission. Therefore, in some embodiments, the first problem may be associated with an ACLR of a transmission by the first device. For example, the first problem may be a problem of a poor ACLR of the transmission, or may be another influence brought about by the poor ACLR of the transmission (i.e., a derivative problem of the poor ACLR).

A source causing the PA to operate in the non-linear region may be a drawback and limitation in the design of a transmission waveform. Therefore, in some embodiments, the first problem may be associated with a transmission waveform of the first device. For example, the first problem may be a problem of designing the transmission waveform. For another example, the first problem may be a problem of adjusting the transmission waveform of the first device.

In some embodiments, the first processing scheme is used for matching the operating characteristic of the PA of the first device. For example, the first processing scheme can be used for matching the non-linear characteristic of the PA of the first device. As an example, the first processing scheme can be used for compensating for non-linear distortion of the PA.

In some embodiments, the first processing scheme is used for adjusting the transmission waveform of the first device. Through the adjustment of the transmission waveform of the first device using the first processing scheme, the transmission waveform can match the operating characteristic of the PA of the first device. The transmission waveform may be associated with the PA. For example, the first processing scheme can be used for adjusting a transmission waveform input from the first device to the PA. For another example, the first processing scheme can be used for adjusting a transmission waveform output from the PA.

In some embodiments, the first processing scheme may include a pre-processing scheme (for example, the above DPD) before the PA.

In some embodiments, the first processing scheme may include a post-processing scheme after the PA (for example, a compensation scheme after non-linear distortion of the PA).

In some embodiments, the first processing scheme may include an internal processing scheme for the PA. For example, the internal processing scheme for the PA may include an internal pre-processing scheme (pre-distortion compensation) and/or an internal post-processing scheme (a compensation scheme after distortion) for the PA.

In some embodiments, the first processing scheme may be associated with a first model (or first function). For example, the first processing scheme may be the first model (or first function).

In some embodiments, the first model may be an AI model or a machine learning (ML) model. At present, for most of basic compensation schemes (for example, the above DPD scheme) for the PA, a polynomial fitting manner is used for compensating for non-linear loss of the PA. However, it is complex to use the polynomial fitting manner for fitting and inversion of a non-linear function of the PA, and the compensation effect is poor. Therefore, by using the AI/ML technology for non-linear fitting for the PA, it is expected to obtain a better compensation effect.

In some embodiments, the first processing scheme may be a neural network. For example, the first processing scheme may be a processing scheme consisting of an N-layer fully-connected network. For another example, the first processing scheme may include an N-layer fully-connected network, and an activation function(s) is provided for the output of one or more layers of the *N*-layer fully-connected network.

In some embodiments, the first processing scheme may be associated with or determined based on a first condition. In other words, the first processing scheme may be used for performing one or more of the following operations under the first condition: matching the operating characteristic of the PA of the first device, adjusting the transmission waveform of the first device, and processing the first problem. As mentioned above, operating characteristics (for example, non-linear characteristics) of the PA are different under different conditions. In embodiments of the disclosure, the first processing scheme is associated with the first condition, and different first conditions may correspond to different first processing schemes, so that an appropriate processing scheme can be selected according to an actual condition in embodiments of the disclosure, thereby improving the compensation effect on the non-linear problem of the PA. For example, in the case where an AI/ML model is used for processing a non-linear problem of the PA under a different condition, the above first processing scheme may be understood as the AI/ML model. Further, multiple AI/ML models can be set for different conditions, and different AI/ML models compensate for non-linear problems of the PA under different conditions.

In some embodiments, the first processing scheme is a first model (or first function). The first processing scheme being associated with the first condition may mean that the first model (or first function) is associated with the first condition. In other words, the first model (or first function) is determined based on the first condition. The first model may have a model identity (or the first function may have a function identity). Therefore, a different first condition may be associated with a different first processing scheme based on the model identity of the first model (or function identity of the first function).

As a more specific example, the first processing scheme is a neural network model, and different neural networks may be determined based on different first conditions. The different neural networks may have different neural network structures and/or neural network parameters. For example, for a different neural network structure, one or more of parameters such as the number (quantity) of layers of a fully-connected network of a neural network, the number of neurons per layer, and a type of an activation function may be different.

In some embodiments, an association relationship between first conditions and first processing schemes may be pre-defined by a protocol.

In some embodiments, the association relationship between first conditions and first processing schemes may be determined by the first device.

In some embodiments, the association relationship between first conditions and first processing schemes may be indicated by a second device, as illustrated in FIG. 5.

In some embodiments, the first condition may be associated with the first processing scheme based on a first identity. The first identity may be an identity of the first condition, or the first identity may be an identity of association between the first processing scheme and the first condition. Several examples of association of the first condition with the first processing scheme based on the first identity are provided in tables below, and for detailed illustrations, reference can be made to the following.

The above first condition may be associated with any information that can influence the operating characteristic (for example, the non-linear characteristic) of the PA. The following will provide detailed illustrative examples of the content of the first condition associated with the first processing scheme.

In some embodiments, the first condition is associated with a device type (for example, a device model) of the first device. In other words, the first condition is determined based on the device type (for example, the device model) of the first device. In other words, the association relationship between first processing schemes and first conditions is influenced by device types of first devices. For example, in the case where the first device is a terminal device or a network device, different models of terminal devices or network devices may lead to differences in operating characteristics of PAs used by the terminal devices or the network devices.

In some embodiments, different types of first devices (for example, different models of terminal devices or different models of network devices) may be associated with different first processing schemes. In other words, different first processing schemes may be used by different types of first devices to process a first problem (for example, a non-linear problem of a PA, a problem of a transmission waveform, or another problem caused by the above problem). For example, a device type may be associated with a first processing scheme. For another example, a device type set (which may contain multiple device types) may be associated with a first processing scheme.

In some embodiments, the device type of the first device may be associated with the first processing scheme based on a first identity. The first identity may be an identity of the first condition, or the first identity may be an identity of association between the first processing scheme and the device type, as illustrated in Table 1.

**Table 1**

| First identity | First condition | First processing scheme |
|---|---|---|
| 1 | Device type A, or device type set A | First processing scheme A (for example, model A) |
| 2 | Device type B, or device type set B | First processing scheme B (for example, model B) |
| 3 | Device type C, or device type set C | First processing scheme C (for example, model C) |
| 4 | Other device types | Other first processing schemes |

As an example, if the first device is device A, model A (or function A) can be used for processing a non-linear problem of a PA of device A (or model A can be used for performing pre-processing or post-processing for the PA of device A, or processing data and waveforms of device A to adapt to an operating characteristic of the PA of device A). Similarly, if the first device is device B, model B (or function B) can be used for processing a non-linear problem of a PA of device B (or model B can be used for performing pre-processing or post-processing for the PA of device B, or processing data and waveforms of device B to adapt to an operating characteristic of the PA of device B).

In some embodiments, the first condition is associated with a type of the PA (for example, a model of the PA or a batch of the PA) of the first device. In other words, the first condition is determined based on the type of the PA of the first device. The association relationship between first processing schemes and first conditions is influenced by types of PAs of the first device.

For example, operating characteristics (for example, non-linear characteristics) of different types of PAs may be different, and different first processing schemes (for example, AI/ML models) may be used for matching the operating characteristics of the PAs.

For another example, operating characteristics (for example, non-linear characteristics) of different types of PAs may be different, and different first processing schemes (for example, AI/ML models) may be used for processing a first problem (for example, a non-linear problem of a PA, a problem of a transmission waveform, or another problem caused by the above problem).

For example, in the case where the first processing scheme is a first model (for example, an AI/ML model), one first model can be used for processing non-linear problems of PAs of one type. For another example, one first model can be used for processing non-linear problems of PAs of multiple types (where the multiple types may be referred to as a type set).

In some embodiments, the type of the PA (or a type set of the PA) of the first device may be associated with the first processing scheme based on a first identity. The first identity may be an identity of the first condition, or the first identity may be an identity of association between the first processing scheme and the type of the PA, as illustrated in Table 2.

**Table 2**

| First identity | First condition | First processing scheme |
|---|---|---|
| 5 | Type D of PA, or type set D of PA | First processing scheme D (for example, model D) |
| 6 | Type E of PA, or type set E of PA | First processing scheme E (for example, model E) |
| 7 | Type F of PA, or type set F of PA | First processing scheme F (for example, model F) |
| 8 | Other types of PAs | Other first processing schemes |

In some embodiments, the first condition is associated with an operating band (or a type of the operating band) of the first device. In other words, the first condition is determined based on the operating band of the first device. In other words, the association relationship between first processing schemes and first conditions is influenced by operating bands of the first device.

For example, operating characteristics (for example, non-linear characteristics) of a PA in different bands may be different, and different first processing schemes (for example, AI/ML models) may be used for matching the operating characteristics of the PA.

For another example, operating characteristics (for example, non-linear characteristics) of a PA in different bands may be different, and different first processing schemes (for example, AI/ML models) may be used for processing a first problem (for example, a non-linear problem of a PA, a problem of a transmission waveform, or another problem caused by the above problem).

For example, in the case where the first processing scheme is a first model (which may be an AI/ML model), one first model can be used for processing a non-linear problem of a PA corresponding to one operating band. For another example, one first model can be used for processing non-linear problems of a PA corresponding to multiple operating bands (where the multiple bands may be referred to as a band set).

In some embodiments, the operating band (or an operating band set) of the first device may be associated with the first processing scheme based on a first identity. The first identity may be an identity of the first condition, or the first identity may be an identity of association between the first processing scheme and the operating band, as illustrated in Table 3.

**Table 3**

| First identity | First condition | First processing scheme |
|---|---|---|
| 9 | Operating band G, or operating band set G | First processing scheme G (for example, model G) |
| 10 | Operating band H, or operating band H | First processing scheme H (for example, model H) |
| 11 | Operating band I, or operating band I | First processing scheme I (for example, model I) |
| 12 | Other operating bands | Other first processing schemes |

In some embodiments, the first condition is associated with an operating bandwidth (or a type of the operating bandwidth) of the first device. In other words, the first condition is determined based on the operating bandwidth of the first device. In other words, the association relationship between first processing schemes and first conditions is influenced by operating bandwidths of the first device.

For example, operating characteristics (for example, non-linear characteristics) of a PA operating at different bandwidths may be different, and different first processing schemes (for example, AI/ML models or functions) may be used for matching the operating characteristics of the PA.

For another example, operating characteristics (for example, non-linear characteristics) of a PA operating at different bandwidths may be different, and different first processing schemes (for example, AI/ML models or functions) may be used for processing a first problem (for example, a non-linear problem of a PA, a problem of a transmission waveform, or another problem caused by the above problem).

For example, in the case where the first processing scheme is a first model (which may be an AI/ML model), one first model can be used for processing a non-linear problem of a PA corresponding to one operating bandwidth. For another example, one first model can be used for processing non-linear problems of a PA corresponding to multiple operating bandwidths (where the multiple bandwidths may be referred to as a bandwidth set).

In some embodiments, the operating bandwidth (or an operating bandwidth set) of the first device may be associated with the first processing scheme based on a first identity. The first identity may be an identity of the first condition, or the first identity may be an identity of association between the first processing scheme and the operating bandwidth, as illustrated in Table 4.

**Table 4**

| First identity | First condition | First processing scheme |
|---|---|---|
| 13 | Operating bandwidth G, or operating bandwidth set G | First processing scheme G (for example, model G) |
| 14 | Operating bandwidth H, or operating bandwidth H | First processing scheme H (for example, model H) |
| 15 | Operating bandwidth I, or operating bandwidth I | First processing scheme I (for example, model I) |
| 16 | Other operating bandwidths | Other first processing schemes |

In some embodiments, the first condition is associated with a power level (or power type) of the first device. In other words, the first condition is determined based on the power level of the first device. In other words, the association relationship between first processing schemes and first conditions is influenced by power levels of the first device. For example, PAs used at different power levels may be different, and thus operating characteristics (non-linear characteristics) of the PAs at the different power levels are also different. For example, at a first power level (for example, a high power level), an operating characteristic (a non-linear characteristic) of a PA is a first characteristic, and at a second power level (for example, a low power level), an operating characteristic (a non-linear characteristic) of a PA is a second characteristic.

In some embodiments, operating characteristics (for example, non-linear characteristics) of PAs at different power levels may be different, and different first processing schemes (for example, AI/ML models) may be used for matching the operating characteristics of the PAs.

In some embodiments, operating characteristics (for example, non-linear characteristics) of PAs at different power levels may be different, and different first processing schemes (for example, AI/ML models) may be used for processing a first problem (for example, a non-linear problem of a PA, a problem of a transmission waveform, or another problem caused by the above problem).

For example, in the case where the first processing scheme is a first model (which may be an AI/ML model), one first model can be used for processing a non-linear problem of a PA corresponding to one power level. For another example, one first model can be used for processing non-linear problems of PAs corresponding to multiple power levels.

In some embodiments, the power level of the first device may be associated with the first processing scheme based on a first identity. The first identity may be an identity of the first condition, or the first identity may be an identity of association between the first processing scheme and the power level, as illustrated in Table 5.

**Table 5**

| First identity | First condition | First processing scheme |
|---|---|---|
| 17 | Power level J (for example, high power level) | First processing scheme J (for example, model J) |
| 18 | Power level K (for example, high power level) | First processing scheme K (for example, model K) |
| 19 | Other power levels | Other first processing schemes |

In some embodiments, the first condition is associated with an operating temperature of the first device. In other words, the first condition is determined based on the operating temperature of the first device. In other words, the association relationship between first processing schemes and first conditions is influenced by operating temperatures of the first device.

For example, at different operating temperatures, operating characteristics (non-linear characteristics) of a PA are different, and thus different first processing schemes may be used for matching the operating characteristics (for example, the non-linear characteristics) of the PA.

For another example, at different operating temperatures, operating characteristics (non-linear characteristics) of a PA are different, and different first processing schemes may be used for processing a first problem (for example, a non-linear problem of a PA, a problem of a transmission waveform, or another problem caused by the above problem).

For example, in the case where the first processing scheme is a first model (which may be an AI/ML model), model L can be used for processing an operating characteristic (for example, a non-linear characteristic) of a PA at operating temperature L, and model M can be used for processing an operating characteristic (for example, a non-linear characteristic) of the PA at operating temperature M.

In some embodiments, the operating temperature of the first device may be associated with the first processing scheme based on a first identity. The first identity may be an identity of the first condition, or the first identity may be an identity of association between the first processing scheme and the operating temperature, as illustrated in Table 6.

**Table 6**

| First identity | First condition | First processing scheme |
|---|---|---|
| 20 | Operating temperature L (for example, high temperature) | First processing scheme L (for example, model L) |
| 21 | Operating temperature M (for example, ambient temperature) | First processing scheme M (for example, model M) |
| 22 | Other operating temperatures | Other first processing schemes |

In some embodiments, the first condition is associated with an operating humidity of the first device. In other words, the first condition is determined based on the operating humidity of the first device. In other words, the association relationship between first processing schemes and first conditions is influenced by operating humidities of the first device.

For example, at different operating humidities, operating characteristics (non-linear characteristics) of a PA are different, and thus different first processing schemes may be used for matching the operating characteristics (for example, the non-linear characteristics) of the PA.

For another example, at different operating humidities, operating characteristics (non-linear characteristics) of a PA are different, and different first processing schemes may be used for processing a first problem (for example, a non-linear problem of a PA, a problem of a transmission waveform, or another problem caused by the above problem).

For example, in the case where the first processing scheme is a first model (which may be an AI/ML model), model N can be used for processing an operating characteristic (for example, a non-linear characteristic) of a PA at operating humidity N, and model O can be used for processing an operating characteristic (for example, a non-linear characteristic) of the PA at operating humidity O.

In some embodiments, the operating humidity of the first device may be associated with the first processing scheme based on a first identity. The first identity may be an identity of the first condition, or the first identity may be an identity of association between the first processing scheme and the operating humidity, as illustrated in Table 7.

**Table 7**

| First identity | First condition | First processing scheme |
|---|---|---|
| 23 | Operating humidity N | First processing scheme N (for example, model N) |
| 24 | Operating humidity O | First processing scheme O (for example, model O) |
| 25 | Other operating humidities | Other first processing schemes |

In some embodiments, the first condition is associated with an operating voltage of the first device. In other words, the first condition is determined based on the operating voltage of the first device. In other words, the association relationship between first processing schemes and first conditions is influenced by operating voltages of the first device.

For example, at different operating voltages, operating characteristics (non-linear characteristics) of a PA are different, and thus different first processing schemes may be used for matching the operating characteristics (for example, the non-linear characteristics) of the PA.

For another example, at different operating voltages, operating characteristics (non-linear characteristics) of a PA are different, and different first processing schemes may be used for processing a first problem (for example, a non-linear problem of a PA, a problem of a transmission waveform, or another problem caused by the above problem).

For example, in the case where the first processing scheme is a first model (which may be an AI/ML model), model P can be used for processing an operating characteristic (for example, a non-linear characteristic) of a PA at operating voltage P, and model Q can be used for processing an operating characteristic (for example, a non-linear characteristic) of the PA at operating voltage Q.

In some embodiments, the operating voltage of the first device may be associated with the first processing scheme based on a first identity. The first identity may be an identity of the first condition, or the first identity may be an identity of association between the first processing scheme and the operating voltage, as illustrated in Table 8.

**Table 8**

| First identity | First condition | First processing scheme |
|---|---|---|
| 23 | Operating voltage P | First processing scheme P (for example, model P) |
| 24 | Operating voltage Q | First processing scheme Q (for example, model Q) |
| 25 | Other operating voltages | Other first processing schemes |

In some embodiments, the first condition is associated with a use environment (or a use region, for example, a cold region, a tropical region, a humid environment, a dry environment) of the first device. In other words, the first condition is determined based on the use environment of the first device. In other words, the association relationship between first processing schemes and first conditions is influenced by use environments of the first device.

For example, in different use environments, operating characteristics (non-linear characteristics) of a PA are different, and thus different first processing schemes may be used for matching the operating characteristics (for example, the non-linear characteristics) of the PA.

For another example, in different use environments, operating characteristics (non-linear characteristics) of a PA are different, and different first processing schemes may be used for processing a first problem (for example, a non-linear problem of a PA, a problem of a transmission waveform, or another problem caused by the above problem).

In some embodiments, the use environment of the first device may be associated with the first processing scheme based on a first identity. The first identity may be an identity of the first condition, or the first identity may be an identity of association between the first processing scheme and the use environment, as illustrated in Table 9.

**Table 9**

| First identity | First condition | First processing scheme |
|---|---|---|
| 26 | Use environment R (for example, cold region) | First processing scheme R (for example, model R) |
| 27 | Use environment S (for example, tropical region) | First processing scheme S (for example, model S) |
| 28 | Other operating voltages | Other first processing schemes |

In some embodiments, the first condition is associated with a data type of the first device (or a type of data input to the PA of the first device). In other words, the first condition is determined based on the data type of the first device. In other words, the association relationship between first processing schemes and first conditions is influenced by data types of the first device.

In some embodiments, the data type of the first device may be determined based on one or more of: modulation information corresponding to data; coding information corresponding to the data; and waveform information corresponding to the data.

For example, if modulation modes, coding modes, or waveforms used by the first device are different, types of data processed by the PA will be different. For example, if modulation modes, coding modes, or waveforms used by the first device are different, the volumes or proportions of data that fall into a non-linear operating region of the PA will be different. In such cases, different first processing schemes may be used for processing different types of data discriminatively.

As an example, the first processing scheme is a first model (for example, an AI/ML model). If modulation mode T (for example, one or more of QPSK, 16QAM, 64QAM, 128QAM, 256QAM, and the like) is used by the first device, model T can be used for processing an operating characteristic (for example, a non-linear characteristic) of the PA. If modulation mode U (for example, one or more of 512QAM, 1024QAM, 2048QAM, 8192QAM, and the like) is used by the first device, model U can be used for processing an operating characteristic (for example, a non-linear characteristic) of the PA.

As another example, the first processing scheme is a first model (for example, an AI/ML model). If coding mode T is used by the first device, model T can be used for processing an operating characteristic (for example, a non-linear characteristic) of the PA. If coding mode U is used by the first device, model U can be used for processing an operating characteristic (for example, a non-linear characteristic) of the PA.

In some embodiments, the data type of the first device may be associated with the first processing scheme based on a first identity. The first identity may be an identity of the first condition, or the first identity may be an identity of association between the first processing scheme and the data type, as illustrated in Table 10.

**Table 10**

| First identity | First condition | First processing scheme |
|---|---|---|
| 29 | Modulation or coding mode T (for example, QPSK modulation) | First processing scheme T (for example, model T) |
| 30 | Modulation or coding mode U (for example, 64QAM modulation) | First processing scheme U (for example, model U) |
| 31 | Modulation or coding mode V (for example, 1024QAM modulation) | First processing scheme V (for example, model V) |
| 32 | Other modulation or coding modes | Other first processing schemes |

In some embodiments, the first condition is associated with a PAPR/ACLR (a PAPR/ACLR level or a PAPR/ACLR property) of a signal (or data transmission) of the first device. In other words, the first condition is determined based on the PAPR/ACLR of the signal of the first device. In other words, the association relationship between first processing schemes and first conditions is influenced by PAPRs/ACLRs of the signal of the first device. Different first processing schemes may be used for processing different PAPRs/ACLRs.

In some embodiments, the PAPR/ACLR of the signal of the first device may be associated with the first processing scheme based on a first identity. The first identity may be an identity of the first condition, or the first identity may be an identity of association between the first processing scheme and the PAPR/ACLR of the signal, as illustrated in Table 11.

**Table 11**

| First identity | First condition | First processing scheme |
|---|---|---|
| 33 | PAPR/ACLR level W | First processing scheme W (for example, model W) |
| 34 | PAPR/ACLR level X | First processing scheme X (for example, model X) |
| 35 | PAPAPR/ACLRRP level Y | First processing scheme Y (for example, model Y) |
| 36 | Other PAPR/ACLR levels | Other first processing schemes |

Among the above influencing factors of the association relationship between first processing schemes and first conditions, an association relationship between first conditions and first processing schemes may be formed based on a specific first condition. For example, different types of the PA may be associated with different AI/ML non-linear processing models (or functions). For another example, different power levels may be associated with different AI/ML non-linear processing models (or functions).

Among the above-listed influencing factors of the association relationship between first processing schemes and first conditions, an association relationship between first conditions and first processing schemes may also be formed based on multiple influencing factors. For example, different combinations may be formed based on a device type, an operating band, and a data type, and then these different combinations are associated with different AI/ML non-linear processing models (or functions). For another example, different combinations may be formed based on an operating temperature, an operating humidity, and an operating voltage of a device, and then these different combinations are associated with different AI/ML non-linear processing models (or functions).

The foregoing has described in detail the content of the first condition or the factors influencing the first processing scheme. The following will provide detailed illustrative examples of a method for determining the first processing scheme in combination with embodiments.

In some embodiments, the first processing scheme may be provided by the first device itself. Accordingly, operations at S310 may include the following. The first device determines the first condition. The first device determines the first processing scheme according to the first condition.

In some embodiments, the first device itself determines the first condition.

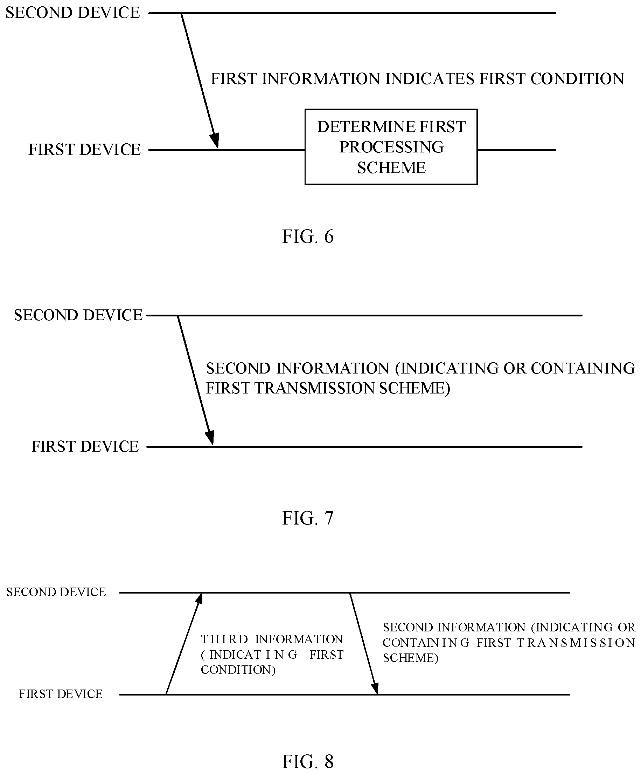

In some embodiments, as illustrated in FIG. 6, the first device determining the first condition may include or be replaced with: the first device receiving first information sent by a second device. The first information may indicate the first condition (or part of the first condition). That is to say, the first device determines the first condition based on the first information sent by the second device. The first information may belong to one type of information in target information (where the target information is used for determining the first processing scheme) sent by the second device to the first device.

In some embodiments, the first information indicates one or more of: information associated with the first condition; and a first identity associated with the first condition. That is to say, the first information may indicate the first condition by indicating one or more of the above information.

For example, when the second device indicates the first condition (or part of the first condition) by using the first information, the content indicated by the first information may include one or more of the following information associated with the first condition: a device type, a type of the PA, an operating band, an operating bandwidth, a power level, an operating temperature, an operating humidity, an operating voltage, a use environment, a data type (for example, a modulation mode or a waveform), a PAPR level, an ACLR level, and the like.

For another example, when the second device indicates the first condition (or part of the first condition) by using the first information, the content indicated by the first information may include, for example, a first identity associated with the first condition.

For example, the first identity may be a first identity of association between the first condition and the first processing scheme. Different first identities of the association indicate one or more of the above information, and for different first processing schemes with which different information may be associated, reference can be made to Tables 1 to 11 mentioned above or combinations of Tables 1 to 11.

For example, the first identity may be an identity of the first condition. Different identities of the first condition are associated with one or more of the above information, and for different first processing schemes with which different information may be associated, reference can be made to Tables 1 to 11 mentioned above or combinations of Tables 1 to 11.

In some embodiments, after the first device determines the first processing scheme, the first device can use, activate, and update the first processing scheme. For example, in the case where the first processing scheme is a first model (or first function), after the first device determines a model identity (or function identity) of the first model, the first device can use, activate, and update the first processing scheme based on the determined model identity (or function identity). In addition, the first device can download and train a corresponding first processing scheme based on the model identity (or function identity).

In some embodiments, the first processing scheme may be indicated or provided by the second device. Accordingly, as illustrated in FIG. 7, operations at S310 may include or be replaced with: the first device receiving second information sent by a second device. The second information indicates or contains the first processing scheme. The second information may belong to one type of information in target information (information for determining the first processing scheme) sent by the second device to the first device.

In some embodiments, the second information may indicate a first model associated with the first processing scheme. For example, the second device may indicate the first model by using a model identity, and the first model can be used for processing the first problem mentioned above.

In some embodiments, the second information may indicate a first function associated with the first processing scheme. For example, the second device may indicate the first function by using a function identity, and the first function can be used for processing the first problem mentioned above.

In some embodiments, the second information may indicate a first dataset. The first dataset can be used for generating (or constructing, or training) the first model or implementing the first function. The first model or the first function can be used for processing the first problem mentioned above.

In some embodiments, the second information may contain model data of the first model associated with the first processing scheme. That is to say, the second device may provide or transmit the first model to the first device. For example, the second information may include one or more of: model structure information, model parameter information, quantization information, interface information, and the like of the first model.

In some embodiments, the second information may contain the first dataset mentioned above. That is to say, the second device may transmit the first dataset to the first device. The first device may generate (or construct, or train) the first model based on the first dataset.

In some embodiments, the second information may indicate the first condition. For example, the second device indicates the first condition to the first device, and the first device may determine the first processing scheme based on an association relationship between first conditions and first processing schemes. The association relationship between first conditions and first processing schemes may be pre-defined by a protocol, determined by the first device, or indicated by the second device to the first device.

In some embodiments, the second information may indicate a first identity. The first identity may be an identity of the first condition, or the first identity may be an identity of association between the first processing scheme and the first condition.

In some embodiments, as illustrated in FIG. 8, before the first device receives the second information sent by the second device, the first device may first send third information to the second device. The third information indicates the first condition.

In some embodiments, the third information indicates one or more of: information associated with the first condition; and a first identity associated with the first condition. That is to say, the third information may indicate the first condition by indicating one or more of the above information.

For example, when the first device indicates the first condition (or part of the first condition) by using the third information, the content indicated by the third information may include one or more of the following information associated with the first condition: a device type, a type of the PA, an operating band, an operating bandwidth, a power level, an operating temperature, an operating humidity, an operating voltage, a use environment, a data type (for example, a modulation mode or a waveform), a PAPR level, an ACLR level, and the like.

For another example, when the first device indicates the first condition (or part of the first condition) by using the third information, the content indicated by the third information may include, for example, a first identity associated with the first condition.

For example, the first identity may be a first identity of association between the first condition and the first processing scheme. Different first identities of the association indicate one or more of the above information, and for different first processing schemes with which different information may be associated, reference can be made to Tables 1 to 11 mentioned above or combinations of Tables 1 to 11.

For example, the first identity may be an identity of the first condition. Different identities of the first condition are associated with one or more of the above information, and for different first processing schemes with which different information may be associated, reference can be made to Tables 1 to 11 mentioned above or combinations of Tables 1 to 11.

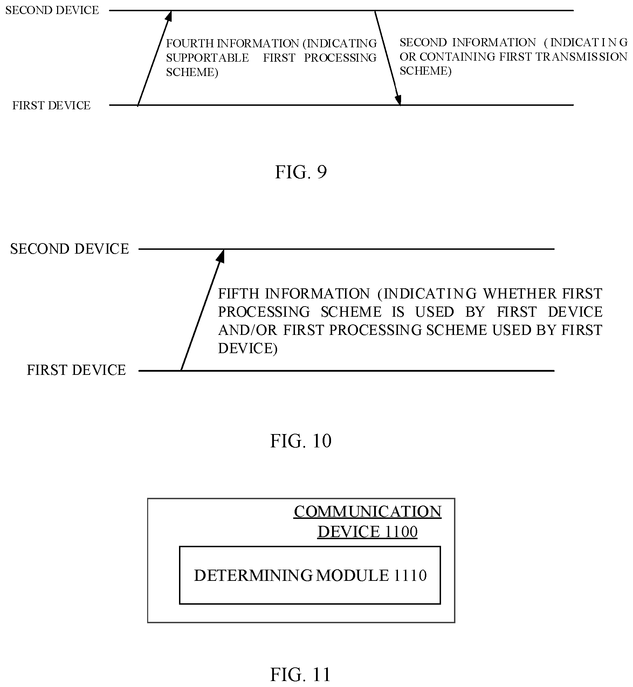

In some embodiments, as illustrated in FIG. 9, before the first device receives the second information sent by the second device, the first device may first send fourth information to the second device. The fourth information may indicate first processing schemes supported by the first device. Further, in some embodiments, the first processing scheme indicated by or contained in the second information may be one of the first processing schemes supported by the first device (i.e., a single scheme or a subset of the first processing schemes supported by the first device). The first device indicating the supportable first processing schemes to the second device helps prevent the scenario where a first processing scheme (for example, an AI/ML model) indicated or transmitted by the second device is not supported by or available for the first device. Therefore, through the interaction of the above fourth information, capability alignment with the first device can be achieved.

In some embodiments, the first device may have multiple first processing schemes, and the first processing scheme used by the first device may be determined based on priorities of the multiple first processing schemes.

In some embodiments, the priorities of the multiple first processing schemes that the first device has may be determined based on one or more of: whether a first processing scheme is indicated or provided by a second device; a use scope of each of the multiple first processing schemes; and the number of first conditions associated with each of the multiple first processing schemes.

In some embodiments, when the first processing scheme is indicated or provided by the second device, the first processing scheme used by the first device is the first processing scheme indicated or provided by the second device.

As an example, the second device is a network device and the first device is a terminal device. When a first processing scheme is indicated or provided by the network device to the terminal device (for example, a model for processing a non-linear problem of a PA is indicated by the network device to the terminal device), the first processing scheme indicated or provided by the network device is used by the terminal device as a currently-used first processing scheme. That is to say, if the terminal device itself has another model for processing the non-linear problem of the PA, and the network device additionally configures for the terminal device a new model for processing the non-linear problem of the PA, then the model configured by the network device is valid.

As another example, when the network device expects to control a non-linear processing scheme for a PA or a waveform adjustment scheme at a cell level or network level, the network device may indicate or provide a first processing scheme to the terminal device (for example, via broadcast, a system information block (SIB), a radio resource control (RRC) message, or an RRC reconfiguration message). After the first processing scheme is indicated or provided by the network device to the terminal device, the first processing scheme indicated or provided by the network device is used by the terminal device. Even if the terminal device itself has another first processing scheme in this case, the network device does not expect the terminal device to continue using the another first processing scheme. For example, the another first processing scheme herein may be a first processing scheme at a terminal device level, a default processing scheme, or a common first processing scheme.

In some embodiments, when the first processing scheme is indicated or provided by the second device, and the first device has a first processing scheme other than the first processing scheme indicated or provided by the second device, the first processing scheme other than the first processing scheme indicated or provided by the second device is used by the first device. That is to say, the first processing scheme indicated or provided by the second device is not used by the first device.

As an example, the second device is a network device and the first device is a terminal device. When a first processing scheme is indicated or provided by the network device to the terminal device (for example, a model for processing a non-linear problem of a PA is indicated by the network device to the terminal device), if the terminal device itself has a capability of processing the non-linear problem of the PA, for example, the terminal device already has a first processing scheme (for example, a model for processing the non-linear problem which is adapted to an operating characteristic of a PA of the terminal device), the first processing scheme indicated or provided by the network device is not used by the terminal device.

As another example, the network device provides a non-linear processing scheme for a PA or a waveform adjustment scheme (for example, an AI/ML model) at a cell level or network level (for example, via broadcast), but for such a cell-level or network-level first processing scheme, differences between terminal devices are not taken into consideration, resulting in an average processing effect. In this case, the terminal device may continue using a first processing scheme at a terminal device level and may not use the cell-level or network-level first processing scheme configured by the network device.

In some embodiments, when the first device has a dedicated first processing scheme and a generic (or common) first processing scheme, the dedicated first processing scheme is used by the first device. For example, the difference between the dedicated first processing scheme and the generic first processing scheme may be that a scope of a first condition associated with the dedicated first processing scheme is smaller or more specific than a scope of a first condition associated with the generic first processing scheme.

In some embodiments, the first device is a terminal device. The dedicated first processing scheme may be indicated or transmitted via an RRC message, a medium access control layer control element (MAC CE), or downlink control information (DCI), and the generic first processing scheme may be indicated or transmitted via a broadcast message, an SIB, or an RRC message.

In some embodiments, a first processing scheme with the smaller number of first conditions associated among the multiple first processing schemes is used by the first device. Alternatively, instead of a common first processing scheme (or a first processing scheme with more conditions associated), a first processing scheme under a specific first condition is used by the first device.

For example, if the first device has first processing scheme A associated with a specific device type, or first processing scheme A is indicated or transmitted to the first device, then first processing scheme A is used by the first device. If the first device also has first processing scheme B applicable to multiple device types or independent of device types, or first processing scheme B is indicated or transmitted to the first device, then first processing scheme B is not used by the first device.

For another example, if the first device has first processing scheme A associated with a specific type of the PA, or first processing scheme A is indicated or transmitted to the first device, then first processing scheme A is used by the first device. If the first device also has first processing scheme B applicable to multiple types of the PA or independent of types of the PA, or first processing scheme B is indicated or transmitted to the first device, then first processing scheme B is not used by the first device.

For another example, if the first device has first processing scheme A associated with a specific operating bandwidth, or first processing scheme A is indicated or transmitted to the first device, then first processing scheme A is used by the first device. If the first device also has first processing scheme B applicable to multiple operating bandwidths or independent of operating bandwidths, or first processing scheme B is indicated or transmitted to the first device, then first processing scheme B is not used by the first device.

For another example, if the first device has first processing scheme A associated with a specific operating band, or first processing scheme A is indicated or transmitted to the first device, then first processing scheme A is used by the first device. If the first device also has first processing scheme B applicable to multiple operating bands or independent of operating bands, or first processing scheme B is indicated or transmitted to the first device, then first processing scheme B is not used by the first device.

For another example, if the first device has first processing scheme A associated with a specific power level, or first processing scheme A is indicated or transmitted to the first device, then first processing scheme A is used by the first device. If the first device also has first processing scheme B applicable to multiple power levels or independent of power levels, or first processing scheme B is indicated or transmitted to the first device, then first processing scheme B is not used by the first device.

For another example, if the first device has first processing scheme A associated with a specific operating temperature, or first processing scheme A is indicated or transmitted to the first device, then first processing scheme A is used by the first device. If the first device also has first processing scheme B applicable to multiple operating temperatures or independent of operating temperatures, or first processing scheme B is indicated or transmitted to the first device, then first processing scheme B is not used by the first device.

For another example, if the first device has first processing scheme A associated with a specific operating humidity, or first processing scheme A is indicated or transmitted to the first device, then first processing scheme A is used by the first device. If the first device also has first processing scheme B applicable to multiple operating humidities or independent of operating humidities, or first processing scheme B is indicated or transmitted to the first device, then first processing scheme B is not used by the first device.

For another example, if the first device has first processing scheme A associated with a specific operating voltage, or first processing scheme A is indicated or transmitted to the first device, then first processing scheme A is used by the first device. If the first device also has first processing scheme B applicable to multiple operating voltages or independent of operating voltages, or first processing scheme B is indicated or transmitted to the first device, then first processing scheme B is not used by the first device.

For another example, if the first device has first processing scheme A associated with a specific use environment, or first processing scheme A is indicated or transmitted to the first device, then first processing scheme A is used by the first device. If the first device also has first processing scheme B applicable to multiple use environments or independent of use environments, or first processing scheme B is indicated or transmitted to the first device, then first processing scheme B is not used by the first device.

For another example, if the first device has first processing scheme A associated with a specific data type, or first processing scheme A is indicated or transmitted to the first device, then first processing scheme A is used by the first device. If the first device also has first processing scheme B applicable to multiple data types or independent of data types, or first processing scheme B is indicated or transmitted to the first device, then first processing scheme B is not used by the first device.

For another example, if the first device has first processing scheme A associated with a specific PAPR level, or first processing scheme A is indicated or transmitted to the first device, then first processing scheme A is used by the first device. If the first device also has first processing scheme B applicable to multiple PAPR levels or independent of PAPR levels, or first processing scheme B is indicated or transmitted to the first device, then first processing scheme B is not used by the first device.

For another example, if the first device has first processing scheme A associated with a specific ACLR level, or first processing scheme A is indicated or transmitted to the first device, then first processing scheme A is used by the first device. If the first device also has first processing scheme B applicable to multiple ACLR levels or independent of ACLR levels, or first processing scheme B is indicated or transmitted to the first device, then first processing scheme B is not used by the first device.

In addition to the above-listed conditions (for example, the specific device type or the specific type of the PA), the specific first condition may also be a combination of the above-listed conditions (for example, a combination of the specific operating temperature, operating humidity, and operating voltage).

In some embodiments, as illustrated in FIG. 10, the first device may also send fifth information to a second device. The fifth information may indicate one or more of: whether the first processing scheme is used by the first device; and the first processing scheme used by the first device. For example, the fifth information may indicate, via 1-bit information, whether the first processing scheme is used by the first device. For another example, the fifth information may indicate an identity of a scheme used by the first device (for example, in the case where the first processing scheme is a first model, the fifth information may indicate a model identity of the first model). For example, when the first processing scheme is determined or used by the first device or the first processing scheme is indicated or transmitted by the second device, the first device indicates to the second device that the first processing scheme is used by the first device or indicates to the second device a specific first processing scheme used by the first device, so that the second device can know that the first processing scheme has been used by the first device for processing the first problem, thereby avoiding a transmission error caused by repeated processing by the second device.

For example, in the case where the first device is a terminal device and the second device is a network device, if the terminal device determines that an AI/ML model for a non-linear problem of a PA (or for adjusting a transmission waveform of the terminal device) is used by the terminal device, the terminal device may report to the network device that the first processing scheme is used by the terminal device.

For another example, in the case where the first device is a terminal device and the second device is a network device, if the terminal device determines that an AI/ML model for a non-linear problem of a PA (or for adjusting a transmission waveform of the terminal device) is used by the terminal device, the terminal device may indicate to the network device an identity of the first processing scheme used by the terminal device (for example, an identity or function identity of the AI/ML model). Alternatively, the terminal device may indicate to the network device part or all of information associated with the first condition. For example, the terminal device may indicate the content of the first condition, or the first terminal device may indicate a first identity associated with the first condition. Based on the above information, the network device can know whether the first processing scheme is used by the terminal device, or can know a specific first processing scheme used by the terminal device.

In some embodiments, if the first device is a base station and the second device is a terminal device, the first device may indicate or transmit certain information (for example, the third information, fourth information, or fifth information above) to the second device in one or more of the following manners: a broadcast message (for example, a master information block (MIB), SIB1, SIBx), an RRC message, an MAC CE, DCI, a downlink message (for example, message B (MsgB), message 2 (Msg 2), message 4 (Msg 4)) during random access, a physical downlink control channel (PDCCH), a physical downlink shared channel (PDSCH), an AI/ML-dedicated downlink channel, and capability indication information of a network device.

In some embodiments, if the first device is a terminal device and the second device is a base station, the second device may indicate or transmit certain information (for example, the first information or second information above) to the first device in one or more of the following manners: a broadcast message (for example, an MIB, SIB1, SIBx), an RRC message, an MAC CE, DCI, a downlink message (for example, MsgB, Msg 2, Msg 4) during random access, a PDCCH, a PDSCH, an AI/ML-dedicated downlink channel, and capability indication information of a network device.

In some embodiments, if the first device is a terminal device and the second device is a network device, the first device may indicate or transmit certain information (for example, the third information, fourth information, or fifth information above) to the second device in one or more of the following manners: an RRC message, an uplink control information (UCI) message, an uplink message (for example, message A (MsgA), message 3 (Msg3)) during random access, a physical uplink control channel (PUCCH), a physical uplink shared channel (PUSCH), an AI/ML-dedicated uplink channel, and capability information of the terminal device.

In some embodiments, if the first device is a terminal device and the second device is a base station, the second device may indicate or transmit certain information (for example, the first information or second information above) to the first device in one or more of the following manners: an RRC message, a UCI message, an uplink message (for example, MsgA, Msg3) during random access, a PUCCH, a PUSCH, an AI/ML-dedicated uplink channel, and capability information of the terminal device.

For example, in the case where the above first processing scheme is an AI/ML model and the AI/ML model is used for processing a non-linear problem of a PA, based on the above content, a method for configuration, update, capability alignment, or use priority-based determination of the AI/ML-based non-linear processing scheme for the PA is provided in embodiments of the disclosure. An association relationship between a different condition (a device type, a type of the PA, an operating band, an operating bandwidth, a power level, an operating temperature, an operating humidity, an operating voltage, a use environment, a data type, a PAPR level, or an ACLR level) and the AI/ML model (for processing the non-linear problem of the PA, a problem of a PAPR of a transmission, a problem of an ACLR of the transmission, a problem of adjusting a transmission waveform, or a problem of generating the transmission waveform) is provided, and model use or management schemes such as AI/ML model indication, priority management, and capability alignment involved in the association relationship are provided. As such, it can be ensured that in the wireless communication system, a processing scheme for a derivative problem (a non-linear problem) of a current PA that best matches the current PA and an operating characteristic of the current PA can be effectively used as needed.

The method embodiments of the disclosure are described in detail above with reference to FIG. 1 to FIG. 10, and the apparatus embodiments of the disclosure will be described in detail below with reference to FIG. 11 to FIG. 13. It may be understood that, illustrations of the method embodiments and illustrations of the apparatus embodiments correspond to each other, and therefore, for parts not described in detail, reference can be made to the above method embodiments.

FIG. 11 is a schematic structural diagram of a communication device provided in an embodiment of the disclosure. The communication device 1100 illustrated in FIG. 11 may be the first device mentioned in any one of the above embodiments. The communication device 1100 may include a determining module 1110. The determining module 1110 may be configured to determine a first processing scheme. The first processing scheme is used for performing one or more of the following operations under a first condition: matching an operating characteristic of a PA of the first device; adjusting a transmission waveform of the first device; and processing a first problem. The first problem is associated with the transmission waveform and/or the operating characteristic of the PA.

In some embodiments, the first processing scheme is used for compensating for non-linear distortion of the PA.

In some embodiments, the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

In some embodiments, the data type is determined based on one or more of: modulation information corresponding to data; coding information corresponding to the data; and waveform information corresponding to the data.

In some embodiments, the first processing scheme is associated with the first condition based on a first identity. The first identity is an identity of the first condition, or the first identity is an identity of association between the first processing scheme and the first condition.

In some embodiments, the determining module 1110 is configured to: determine the first condition; and determine the first processing scheme according to the first condition.

In some embodiments, the determining module 1110 is configured to receive first information sent by a second device. The first information indicates the first condition.

In some embodiments, the first information indicates one or more of: information associated with the first condition; and a first identity associated with the first condition. The first identity is an identity of the first condition, or the first identity is an identity of association between the first processing scheme and the first condition.

In some embodiments, the determining module 1110 is configured to receive second information sent by a second device. The second information indicates or contains the first processing scheme.

In some embodiments, the second information indicates a first model associated with the first processing scheme. Alternatively, the second information indicates a first function associated with the first processing scheme. Alternatively, the second information contains model data of the first model associated with the first processing scheme. Alternatively, the second information indicates a first dataset, where the first dataset is used for generating the first model or implementing the first function. Alternatively, the second information contains the first dataset. Alternatively, the second information indicates a first identity, where the first identity is an identity of the first condition, or the first identity is an identity of association between the first processing scheme and the first condition.

In some embodiments, the communication device 1100 further includes a first communication module. The first communication module is configured to send third information to the second device before sending target information to the first device. The third information indicates the first condition.

In some embodiments, the communication device 1100 further includes a second communication module. The second communication module is configured to send fourth information to the second device before receiving the second information sent by the second device. The fourth information indicates first processing schemes supported by the first device.

In some embodiments, the first processing scheme indicated by or contained in the second information is one of the first processing schemes supported by the first device.

In some embodiments, the first device has multiple first processing schemes, and the first processing scheme used by the first device is determined based on priorities of the multiple first processing schemes.

In some embodiments, the priorities of the multiple first processing schemes are determined based on one or more of: whether a first processing scheme is indicated or provided by a second device; a use scope of each of the multiple first processing schemes; and the number of first conditions associated with each of the multiple first processing schemes.

In some embodiments, when the first processing scheme is indicated or provided by the second device, the first processing scheme used by the first device is the first processing scheme indicated or provided by the second device. Alternatively, when the first processing scheme is indicated or provided by the second device, and the first device has a first processing scheme other than the first processing scheme indicated or provided by the second device, the first processing scheme other than the first processing scheme indicated or provided by the second device is used by the first device. Alternatively, when the first device has a dedicated first processing scheme and a generic first processing scheme, the dedicated first processing scheme is used by the first device. Alternatively, a first processing scheme with the smaller number of first conditions associated among the multiple first processing schemes is used by the first device.

In some embodiments, the communication device 1100 further includes a third communication module. The third communication module is configured to send fifth information to a second device. The fifth information indicates one or more of: whether the first processing scheme is used by the first device; and the first processing scheme used by the first device.

In some embodiments, the first processing scheme is associated with a first model or a first function.

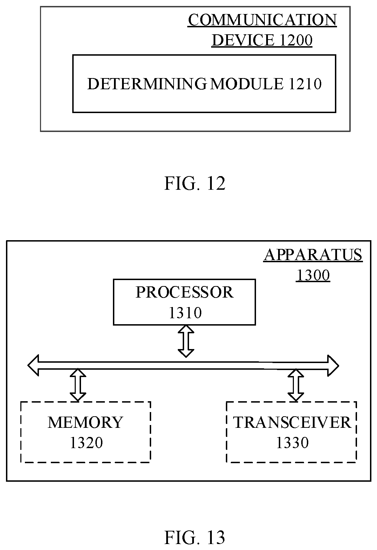

FIG. 12 is a schematic structural diagram of a communication device provided in another embodiment of the disclosure. The communication device 1200 illustrated in FIG. 12 may be the second device mentioned in any one of the above embodiments. The communication device 1200 may include a communication module 1210. The communication module 1210 may be configured to send target information to a first device, where the target information is used for determining a first processing scheme. The first processing scheme is used for performing one or more of the following operations under a first condition: matching an operating characteristic of a PA of the first device; adjusting a transmission waveform of the first device; and processing a first problem. The first problem is associated with the transmission waveform and/or the operating characteristic of the PA.

In some embodiments, the first processing scheme is used for compensating for non-linear distortion of the PA.

In some embodiments, the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

In some embodiments, the data type is determined based on one or more of: modulation information corresponding to data; coding information corresponding to the data; and waveform information corresponding to the data.

In some embodiments, the first processing scheme is associated with the first condition based on a first identity. The first identity is an identity of the first condition, or the first identity is an identity of association between the first processing scheme and the first condition.

In some embodiments, the target information includes first information, and the first information indicates the first condition.

In some embodiments, the first information indicates one or more of: information associated with the first condition; and a first identity associated with the first condition. The first identity is an identity of the first condition, or the first identity is an identity of association between the first processing scheme and the first condition.

In some embodiments, the target information includes second information, and the second information indicates or contains the first processing scheme.

In some embodiments, the second information indicates a first model associated with the first processing scheme. Alternatively, the second information indicates a first function associated with the first processing scheme. Alternatively, the second information contains model data of the first model associated with the first processing scheme. Alternatively, the second information indicates a first dataset, where the first dataset is used for generating the first model or implementing the first function. Alternatively, the second information contains the first dataset. Alternatively, the second information indicates a first identity, where the first identity is an identity of the first condition, or the first identity is an identity of association between the first processing scheme and the first condition.

In some embodiments, the communication module 1210 is further configured to send third information to the second device before sending the target information to the first device. The third information indicates the first condition.

In some embodiments, the communication module 1210 is further configured to receive third information sent by the first device. The third information indicates first processing schemes supported by the first device.

In some embodiments, the first processing scheme indicated by or contained in the second information is one of the first processing schemes supported by the first device.

In some embodiments, the first device has multiple first processing schemes, and the first processing scheme used by the first device is determined based on priorities of the multiple first processing schemes.

In some embodiments, the priorities of the multiple first processing schemes are determined based on one or more of: whether a first processing scheme is indicated or provided by the second device; a use scope of each of the multiple first processing schemes; and the number of first conditions associated with each of the multiple first processing schemes.

In some embodiments, when the first processing scheme is indicated or provided by the second device, the first processing scheme used by the first device is the first processing scheme indicated or provided by the second device. Alternatively, when the first processing scheme is indicated or provided by the second device, and the first device has a first processing scheme other than the first processing scheme indicated or provided by the second device, the first processing scheme other than the first processing scheme indicated or provided by the second device is used by the first device. Alternatively, when the first device has a dedicated first processing scheme and a generic first processing scheme, the dedicated first processing scheme is used by the first device. Alternatively, a first processing scheme with the smaller number of first conditions associated among the multiple first processing schemes is used by the first device.

In some embodiments, the communication module 1210 is further configured to receive fifth information sent by the second device. The fifth information indicates one or more of: whether the first processing scheme is used by the first device; and the first processing scheme used by the first device.

In some embodiments, the first processing scheme is associated with a first model or a first function.

FIG. 13 is a schematic structural diagram of an apparatus provided in embodiments of the disclosure. A dashed line in FIG. 13 indicates that the unit or module is optional. The apparatus 1300 may be configured to implement the method described in the above method embodiments. The apparatus 1300 may be a chip, a terminal device, or a network device.

The apparatus 1300 may include one or more processors 1310. The processor 1310 may support the apparatus 1300 to implement the method described in the above method embodiments. The processor 1310 may be a general-purpose processor or a special-purpose processor. For example, the processor may be a central processing unit (CPU). Alternatively, the processor may be another general-purpose processor, a digital signal processor (DSP), an application specific integrated circuit (ASIC), a field programmable gate array (FPGA), or another programmable logic device, discrete gate or transistor logic device, or discrete hardware component. The general-purpose processor may be a microprocessor, or the processor may be any conventional processor.

The apparatus 1300 may further include one or more memories 1320. The memory 1320 is configured to store a program. The program may be executed by the processor 1310, so that the processor 1310 performs the method described in the above method embodiments. The memory 1320 may be independent from the processor 1310, or may be integrated into the processor 1310.

The apparatus 1300 may further include a transceiver 1330. The processor 1310 may communicate with other devices or chips via the transceiver 1330. For example, the processor 1310 may perform data transmission and reception with other devices or chips via the transceiver 1330.

A computer-readable storage medium is further provided in embodiments of the disclosure. The computer-readable storage medium is configured to store a program. The computer-readable storage medium may be applied to the communication device provided in embodiments of the disclosure, and the program causes a computer to perform the method performed by the communication device in various embodiments of the disclosure.

A computer program product is further provided in embodiments of the disclosure. The computer program product includes a program. The computer program product may be applied to the communication device provided in embodiments of the disclosure, and the program causes a computer to perform the method implemented by the communication device in various embodiments of the disclosure.

A computer program is further provided in embodiments of the disclosure. The computer program may be applied to the communication device provided in embodiments of the disclosure, and the computer program causes a computer to perform the method performed by the communication device in various embodiments of the disclosure.

It may be understood that, the terms "system" and "network" herein are usually used interchangeably throughout this disclosure. In addition, the terms used in the disclosure are only intended for explaining embodiments of the disclosure, rather than limiting the disclosure. The terms "first", "second", "third", and "fourth", etc. in the specification and claims of the disclosure and the accompanying drawings are used for distinguishing different objects, and are not necessarily used for describing a particular order. Furthermore, the terms "include", "comprise", and "have" as well as variations thereof are intended to cover non-exclusive inclusion.

"Indication" referred to in embodiments of the disclosure may be a direct indication, may be an indirect indication, or may mean that there is an association relationship. For example, A indicating B may mean that A directly indicates B, for instance, B can be obtained according to A; may mean that A indirectly indicates B, for instance, A indicates C, and B can be obtained according to C; or may mean that that there is an association relationship between A and B.

In embodiments of the disclosure, "B corresponding to A" means that B is associated with A, and B can be determined according to A. However, it may also be understood that, "B can be determined according to A" does not mean that B can be determined only according to A, and instead, B can be determined according to A and/or other information.

In embodiments of the disclosure, the term "correspondence" may mean that there is a direct or indirect correspondence between the two, may mean that there is an association relationship between the two, or may mean a relationship of indicating and being indicated or configuring and being configured, etc.

In embodiments of the disclosure, the "pre-defined" or "pre-configured" can be implemented by pre-storing a corresponding code or table in a device (for example, including the terminal device and the network device) or in other manners that can be used for indicating related information, and the disclosure is not limited in this regard. For example, the "pre-defined" may mean defined in a protocol.

In embodiments of the disclosure, the "protocol" may refer to a communication standard protocol, which may include, for example, an LTE protocol, an NR protocol, and a protocol applied to a future communication system, and the disclosure is not limited in this regard.

In embodiments of the disclosure, the term "and/or" only describes an association relationship between associated objects, which means that there can be three relationships. For example, A and/or B can mean A alone, both A and B exist, and B alone. In addition, the character "/" herein generally indicates that the associated objects are in an "or" relationship.

In various embodiments of the disclosure, the magnitude of a sequence number of each process does not mean an order of execution, and the order of execution of each process may be determined by its function and an internal logic and shall not constitute any limitation to the implementation of embodiments of the disclosure.

It will be appreciated that the systems, apparatuses, and methods disclosed in embodiments of the disclosure may also be implemented in various other manners. For example, the above apparatus embodiments are merely illustrative, e.g., the division of units is only a division of logical functions, and other manners of division may be available in practice, e.g., multiple units or assemblies may be combined or may be integrated into another system, or some features may be ignored or skipped. In other aspects, the coupling or direct coupling or communication connection as illustrated or discussed may be an indirect coupling or communication connection through some interface, device, or unit, and may be electrical, mechanical, or otherwise.

Separated units as illustrated may or may not be physically separated. Components displayed as units may or may not be physical units, and may reside at one location or may be distributed to multiple networked units. Some or all of the units may be selectively adopted according to practical needs to achieve desired objectives of the disclosure.

In addition, various functional units described in various embodiments of the disclosure may be integrated into one processing unit or may be present as a number of physically separated units, and two or more units may be integrated into one.

All or some of the above embodiments can be implemented by software, hardware, firmware, or any combination thereof. When implemented by software, all or some the above embodiments can be implemented in the form of a computer program product. The computer program product includes one or more computer instructions. When the computer instructions are applied and executed on a computer, all or some the operations or functions of the embodiments of the disclosure are performed. The computer may be a general-purpose computer, a special-purpose computer, a computer network, or another programmable apparatus. The computer instruction can be stored in a computer-readable storage medium, or transmitted from one computer-readable storage medium to another computer-readable storage medium. For example, the computer instruction can be transmitted from one website, computer, server, or data center to another website, computer, server, or data center in a wired manner or in a wireless manner. Examples of the wired manner can be a coaxial cable, an optical fiber, a digital subscriber line (DSL), etc. The wireless manner can be, for example, infrared, wireless, microwave, etc. The computer-readable storage medium may be any computer accessible usable-medium or a data storage device such as a server, a data center, or the like which integrates one or more usable media. The usable medium may be a magnetic medium (such as a soft disk, a hard disk, or a magnetic tape), an optical medium (such as a digital video disc (DVD)), or a semiconductor medium (such as a solid state disk (SSD)), etc.

The foregoing elaborations are merely implementations of the disclosure, but are not intended to limit the protection scope of the disclosure. Any variation or replacement easily thought of by those skilled in the art within the technical scope disclosed in the disclosure shall belong to the protection scope of the disclosure. Therefore, the protection scope of the disclosure shall be subject to the protection scope of the claims.

## Claims

1. A method for wireless communication, comprising:
determining, by a first device, a first processing scheme;
wherein the first processing scheme is used for performing one or more of the following operations under a first condition:
matching an operating characteristic of a power amplifier (PA) of the first device;
adjusting a transmission waveform of the first device; and
processing a first problem, wherein the first problem is associated with the transmission waveform and/or the operating characteristic of the PA.

2. The method of claim 1, wherein the first processing scheme is used for compensating for non-linear distortion of the PA.

3. The method of claim 1 or 2, wherein the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

4. The method of claim 3, wherein the data type is determined based on one or more of:
modulation information corresponding to data;
coding information corresponding to the data; and
waveform information corresponding to the data.

5. The method of any one of claims 1 to 4, wherein the first processing scheme is associated with the first condition based on a first identity;
wherein the first identity is an identity of the first condition, or the first identity is an identity of association between the first processing scheme and the first condition.

6. The method of any one of claims 1 to 5, wherein determining, by the first device, the first processing scheme comprises:
determining, by the first device, the first condition; and
determining, by the first device, the first processing scheme according to the first condition.

7. The method of claim 6, wherein determining, by the first device, the first condition comprises:
receiving, by the first device, first information sent by a second device, wherein the first information indicates the first condition.

8. The method of claim 7, wherein the first information indicates one or more of:
information associated with the first condition; and
a first identity associated with the first condition;
wherein the first identity is an identity of the first condition, or the first identity is an identity of association between the first processing scheme and the first condition.

9. The method of any one of claims 1 to 5, wherein determining, by the first device, the first processing scheme comprises:
receiving, by the first device, second information sent by a second device, wherein the second information indicates or contains the first processing scheme.

10. The method of claim 9, wherein
the second information indicates a first model associated with the first processing scheme; or
the second information indicates a first function associated with the first processing scheme; or
the second information contains model data of the first model associated with the first processing scheme; or
the second information indicates a first dataset, wherein the first dataset is used for generating the first model or implementing the first function; or
the second information contains the first dataset; or
the second information indicates a first identity, wherein the first identity is an identity of the first condition, or the first identity is an identity of association between the first processing scheme and the first condition.

11. The method of claim 9 or 10, wherein before sending, by the second device, target information to the first device, the method further comprises:
sending, by the first device, third information to the second device, wherein the third information indicates the first condition.

12. The method of any one of claims 9 to 11, wherein before receiving, by the first device, the second information sent by the second device, the method further comprises:
sending, by the first device, fourth information to the second device, wherein the fourth information indicates first processing schemes supported by the first device.

13. The method of claim 12, wherein the first processing scheme indicated by or contained in the second information is one of the first processing schemes supported by the first device.

14. The method of any one of claims 1 to 13, wherein the first device has a plurality of first processing schemes, and the first processing scheme used by the first device is determined based on priorities of the plurality of first processing schemes.

15. The method of claim 14, wherein the priorities of the plurality of first processing schemes are determined based on one or more of:
whether a first processing scheme is indicated or provided by a second device;
a use scope of each of the plurality of first processing schemes; and
a number of first conditions associated with each of the plurality of first processing schemes.

16. The method of claim 15, wherein
in response to the first processing scheme being indicated or provided by the second device, the first processing scheme used by the first device is the first processing scheme indicated or provided by the second device; or
in response to the first processing scheme being indicated or provided by the second device, and the first device has a first processing scheme other than the first processing scheme indicated or provided by the second device, the first processing scheme other than the first processing scheme indicated or provided by the second device is used by the first device; or
in response to the first device has a dedicated first processing scheme and a generic first processing scheme, the dedicated first processing scheme is used by the first device; or
a first processing scheme with a smaller number of first conditions associated among the plurality of first processing schemes is used by the first device.

17. The method of any one of claims 1 to 16, further comprising:
sending, by the first device, fifth information to a second device, wherein the fifth information indicates one or more of:
whether the first processing scheme is used by the first device; and
the first processing scheme used by the first device.

18. The method of any one of claims 1 to 17, wherein the first processing scheme is associated with a first model or a first function.

19. A method for wireless communication, comprising:
sending, by a second device, target information to a first device, wherein the target information is used for determining a first processing scheme;
wherein the first processing scheme is used for performing one or more of the following operations under a first condition:
matching an operating characteristic of a power amplifier (PA) of the first device;
adjusting a transmission waveform of the first device; and
processing a first problem, wherein the first problem is associated with the transmission waveform and/or the operating characteristic of the PA.

20. The method of claim 19, wherein the first processing scheme is used for compensating for non-linear distortion of the PA.

21. The method of claim 19 or 20, wherein the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

22. The method of claim 21, wherein the data type is determined based on one or more of:
modulation information corresponding to data;
coding information corresponding to the data; and
waveform information corresponding to the data.

23. The method of any one of claims 19 to 22, wherein the first processing scheme is associated with the first condition based on a first identity;
wherein the first identity is an identity of the first condition, or the first identity is an identity of association between the first processing scheme and the first condition.

24. The method of any one of claims 19 to 23, wherein the target information comprises first information, and the first information indicates the first condition.

25. The method of claim 24, wherein the first information indicates one or more of:
information associated with the first condition; and
a first identity associated with the first condition;
wherein the first identity is an identity of the first condition, or the first identity is an identity of association between the first processing scheme and the first condition.

26. The method of any one of claims 19 to 23, wherein the target information comprises second information, and the second information indicates or contains the first processing scheme.

27. The method of claim 26, wherein
the second information indicates a first model associated with the first processing scheme; or
the second information indicates a first function associated with the first processing scheme; or
the second information contains model data of the first model associated with the first processing scheme; or
the second information indicates a first dataset, wherein the first dataset is used for generating the first model or implementing the first function; or
the second information contains the first dataset; or
the second information indicates a first identity, wherein the first identity is an identity of the first condition, or the first identity is an identity of association between the first processing scheme and the first condition.

28. The method of claim 26 or 27, wherein before sending, by the second device, the target information to the first device, the method further comprises:
sending, by the first device, third information to the second device, wherein the third information indicates the first condition.

29. The method of any one of claims 26 to 28, further comprising:
receiving, by the second device, third information sent by the first device, wherein the third information indicates first processing schemes supported by the first device.

30. The method of claim 29, wherein the first processing scheme indicated by or contained in the second information is one of the first processing schemes supported by the first device.

31. The method of any one of claims 19 to 30, wherein the first device has a plurality of first processing schemes, and the first processing scheme used by the first device is determined based on priorities of the plurality of first processing schemes.

32. The method of claim 31, wherein the priorities of the plurality of first processing schemes are determined based on one or more of:
whether a first processing scheme is indicated or provided by the second device;
a use scope of each of the plurality of first processing schemes; and
a number of first conditions associated with each of the plurality of first processing schemes.

33. The method of claim 32, wherein
in response to the first processing scheme being indicated or provided by the second device, the first processing scheme used by the first device is the first processing scheme indicated or provided by the second device; or
in response to the first processing scheme being indicated or provided by the second device, and the first device has a first processing scheme other than the first processing scheme indicated or provided by the second device, the first processing scheme other than the first processing scheme indicated or provided by the second device is used by the first device; or
in response to the first device has a dedicated first processing scheme and a generic first processing scheme, the dedicated first processing scheme is used by the first device; or
a first processing scheme with a smaller number of first conditions associated among the plurality of first processing schemes is used by the first device.

34. The method of any one of claims 19 to 33, further comprising:
receiving, by the second device, fifth information sent by the second device, wherein the fifth information indicates one or more of:
whether the first processing scheme is used by the first device; and
the first processing scheme used by the first device.

35. The method of any one of claims 19 to 34, wherein the first processing scheme is associated with a first model or a first function.

36. A communication device, wherein the communication device is a first device, and the first device comprises:
a determining module configured to determine a first processing scheme;
wherein the first processing scheme is used for performing one or more of the following operations under a first condition:
matching an operating characteristic of a power amplifier (PA) of the first device;
adjusting a transmission waveform of the first device; and
processing a first problem, wherein the first problem is associated with the transmission waveform and/or the operating characteristic of the PA.

37. The communication device of claim 36, wherein the first processing scheme is used for compensating for non-linear distortion of the PA.

38. The communication device of claim 36 or 37, wherein the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

39. The communication device of claim 38, wherein the data type is determined based on one or more of:
modulation information corresponding to data;
coding information corresponding to the data; and
waveform information corresponding to the data.

40. The communication device of any one of claims 36 to 39, wherein the first processing scheme is associated with the first condition based on a first identity;
wherein the first identity is an identity of the first condition, or the first identity is an identity of association between the first processing scheme and the first condition.

41. The communication device of any one of claims 36 to 40, wherein the determining module is configured to:
determine the first condition; and
determine the first processing scheme according to the first condition.

42. The communication device of claim 41, wherein the determining module is configured to:
receive first information sent by a second device, wherein the first information indicates the first condition.

43. The communication device of claim 42, wherein the first information indicates one or more of:
information associated with the first condition; and
a first identity associated with the first condition;
wherein the first identity is an identity of the first condition, or the first identity is an identity of association between the first processing scheme and the first condition.

44. The communication device of any one of claims 36 to 40, wherein the determining module is configured to:
receive second information sent by a second device, wherein the second information indicates or contains the first processing scheme.

45. The communication device of claim 44, wherein
the second information indicates a first model associated with the first processing scheme; or
the second information indicates a first function associated with the first processing scheme; or
the second information contains model data of the first model associated with the first processing scheme; or
the second information indicates a first dataset, wherein the first dataset is used for generating the first model or implementing the first function; or
the second information contains the first dataset; or
the second information indicates a first identity, wherein the first identity is an identity of the first condition, or the first identity is an identity of association between the first processing scheme and the first condition.

46. The communication device of claim 44 or 45, wherein the communication device further comprises:
a first communication module configured to send third information to the second device before sending target information to the first device, wherein the third information indicates the first condition.

47. The communication device of any one of claims 44 to 46, wherein the communication device further comprises:
a second communication module configured to send fourth information to the second device before receiving the second information sent by the second device, wherein the fourth information indicates first processing schemes supported by the first device.

48. The communication device of claim 47, wherein the first processing scheme indicated by or contained in the second information is one of the first processing schemes supported by the first device.

49. The communication device of any one of claims 36 to 48, wherein the first device has a plurality of first processing schemes, and the first processing scheme used by the first device is determined based on priorities of the plurality of first processing schemes.

50. The communication device of claim 49, wherein the priorities of the plurality of first processing schemes are determined based on one or more of:
whether a first processing scheme is indicated or provided by a second device;
a use scope of each of the plurality of first processing schemes; and
a number of first conditions associated with each of the plurality of first processing schemes.

51. The communication device of claim 50, wherein
in response to the first processing scheme being indicated or provided by the second device, the first processing scheme used by the first device is the first processing scheme indicated or provided by the second device; or
in response to the first processing scheme being indicated or provided by the second device, and the first device has a first processing scheme other than the first processing scheme indicated or provided by the second device, the first processing scheme other than the first processing scheme indicated or provided by the second device is used by the first device; or
in response to the first device has a dedicated first processing scheme and a generic first processing scheme, the dedicated first processing scheme is used by the first device; or
a first processing scheme with a smaller number of first conditions associated among the plurality of first processing schemes is used by the first device.

52. The communication device of any one of claims 36 to 51, wherein the communication device further comprises:
a third communication module configured to send fifth information to a second device, wherein the fifth information indicates one or more of:
whether the first processing scheme is used by the first device; and
the first processing scheme used by the first device.

53. The communication device of any one of claims 36 to 52, wherein the first processing scheme is associated with a first model or a first function.

54. A communication device, wherein the communication device is a second device, and the second device comprises:
a communication module configured to send target information to a first device, wherein the target information is used for determining a first processing scheme;
wherein the first processing scheme is used for performing one or more of the following operations under a first condition:
matching an operating characteristic of a power amplifier (PA) of the first device;
adjusting a transmission waveform of the first device; and
processing a first problem, wherein the first problem is associated with the transmission waveform and/or the operating characteristic of the PA.

55. The communication device of claim 54, wherein the first processing scheme is used for compensating for non-linear distortion of the PA.

56. The communication device of claim 54 or 55, wherein the first condition is associated with one or more of the following information of the first device: a device type, a type of the PA, an operating band, an operating bandwidth, a power level, an operating temperature, an operating humidity, an operating voltage, a use environment, a data type, and a peak to average power ratio and an adjacent channel leakage ratio of a signal.

57. The communication device of claim 55, wherein the data type is determined based on one or more of:
modulation information corresponding to data;
coding information corresponding to the data; and
waveform information corresponding to the data.

58. The communication device of any one of claims 54 to 57, wherein the first processing scheme is associated with the first condition based on a first identity;
wherein the first identity is an identity of the first condition, or the first identity is an identity of association between the first processing scheme and the first condition.

59. The communication device of any one of claims 54 to 58, wherein the target information comprises first information, and the first information indicates the first condition.

60. The communication device of claim 59, wherein the first information indicates one or more of:
information associated with the first condition; and
a first identity associated with the first condition;
wherein the first identity is an identity of the first condition, or the first identity is an identity of association between the first processing scheme and the first condition.

61. The communication device of any one of claims 54 to 58, wherein the target information comprises second information, and the second information indicates or contains the first processing scheme.

62. The communication device of claim 61, wherein
the second information indicates a first model associated with the first processing scheme; or
the second information indicates a first function associated with the first processing scheme; or
the second information contains model data of the first model associated with the first processing scheme; or
the second information indicates a first dataset, wherein the first dataset is used for generating the first model or implementing the first function; or
the second information contains the first dataset; or
the second information indicates a first identity, wherein the first identity is an identity of the first condition, or the first identity is an identity of association between the first processing scheme and the first condition.

63. The communication device of claim 61 or 62, wherein the communication module is further configured to:
send third information to the second device before sending the target information to the first device, wherein the third information indicates the first condition.

64. The communication device of any one of claims 61 to 63, wherein the communication module is further configured to:
receive third information sent by the first device, wherein the third information indicates first processing schemes supported by the first device.

65. The communication device of claim 64, wherein the first processing scheme indicated by or contained in the second information is one of the first processing schemes supported by the first device.

66. The communication device of any one of claims 54 to 65, wherein the first device has a plurality of first processing schemes, and the first processing scheme used by the first device is determined based on priorities of the plurality of first processing schemes.

67. The communication device of claim 66, wherein the priorities of the plurality of first processing schemes are determined based on one or more of:
whether a first processing scheme is indicated or provided by the second device;
a use scope of each of the plurality of first processing schemes; and
a number of first conditions associated with each of the plurality of first processing schemes.

68. The communication device of claim 67, wherein
in response to the first processing scheme being indicated or provided by the second device, the first processing scheme used by the first device is the first processing scheme indicated or provided by the second device; or
in response to the first processing scheme being indicated or provided by the second device, and the first device has a first processing scheme other than the first processing scheme indicated or provided by the second device, the first processing scheme other than the first processing scheme indicated or provided by the second device is used by the first device; or
in response to the first device has a dedicated first processing scheme and a generic first processing scheme, the dedicated first processing scheme is used by the first device; or
a first processing scheme with a smaller number of first conditions associated among the plurality of first processing schemes is used by the first device.

69. The communication device of any one of claims 54 to 68, wherein the communication module is further configured to:
receive fifth information sent by the second device, wherein the fifth information indicates one or more of:
whether the first processing scheme is used by the first device; and
the first processing scheme used by the first device.

70. The communication device of any one of claims 54 to 69, wherein the first processing scheme is associated with a first model or a first function.

71. A communication device, comprising:
a transceiver, a memory, and a processor, wherein the memory is configured to store a program, and the processor is configured to invoke the program stored in the memory and control the transceiver to receive or send a signal, to cause the communication device to perform the method of any one of claims 1 to 18 or the method of any one of claims 19 to 35.

72. An apparatus, comprising:
a processor configured to invoke a program stored in a memory, to cause the apparatus to perform the method of any one of claims 1 to 18 or the method of any one of claims 19 to 35.

73. A chip, comprising:
a processor configured to invoke a program stored in a memory, to cause a device equipped with the chip to perform the method of any one of claims 1 to 18 or the method of any one of claims 19 to 35.

74. A computer-readable storage medium configured to store a program which causes a computer to perform the method of any one of claims 1 to 18 or the method of any one of claims 19 to 35.

75. A computer program product comprising a program which causes a computer to perform the method of any one of claims 1 to 18 or the method of any one of claims 19 to 35.

76. A computer program causing a computer to perform the method of any one of claims 1 to 18 or the method of any one of claims 19 to 35.
